# FASCICULE DE BREVET EUROPEEN

(11) **EP 2 652 747 B1**
(45) Date de publication et mention de la délivrance du brevet: **04.05.2016**
(21) Numéro de dépôt: 11797218.2
(22) Date de dépôt: 09.12.2011
(51) Int. Cl.: H01B 1/02, H01F 6/06, H01L 39/24, H01B 11/18, H01B 13/016

(54) **FIL CONDUCTEUR COMPOSITE A BASE DE NANOTUBES ET NANOFIBRES, MICROSTRUCTURE CO-AXIALE COMPRENANT UNE MATRICE DE CUIVRE ET LESDITS NANOTUBES ET NANOFIBRES ET PROCEDE DE FABRICATION DE LADITE MICROSTRUCTURE**
ZUSAMMENGESETZTES LEITFÄHIGES KABEL MIT NANORÖHRCHEN UND NANOFASERN, KOAXIALE MIKROSTRUKTUR MIT EINER KUPFERMATRIX UND DIESEN NANORÖHRCHEN UND NANOFASERN SOWIE VERFAHREN ZUR HERSTELLUNG DIESER MIKROSTRUKTUR
COMPOSITE CONDUCTIVE CABLE COMPRISING NANOTUBES AND NANOFIBERS, COAXIAL MICROSTRUCTURE INCLUDING A COPPER MATRIX AND SAID NANOTUBES AND NANOFIBERS, AND METHOD FOR MANUFACTURING SAID MICROSTRUCTURE

(30) Priorité: 13.12.2010 FR 1060409
(43) Date de publication de la demande: 23.10.2013
(73) Titulaire: Centre National de la Recherche Scientifique, 75016 Paris (FR); Université De Poitiers, 86034 Poitiers Cedex (FR)
(72) Inventeur: THILLY, Ludovic, F-86000 Poitiers (FR); LECOUTURIER, Florence, F-31130 Balma (FR); DUBOIS, Jean-Baptiste, F-86130 Jaunay Clan (FR); FERREIRA, Nelson, F-31550 Cintegabelle (FR); RENAULT, Pierre-Olivier, F-86000 Poitiers (FR); OLIER, Patrick, F-92320 Chatillon (FR)
(74) Mandataire: Esselin, Sophie
(86) Numéro de dépôt international: PCT/EP2011/072345
(87) Numéro de publication internationale: WO 2012/080133

(56) Documents cités:
- EP-A2- 0 346 124
- EP-A2- 0 731 473
- THILLY L ET AL: "Recent Progress in the Development of Ultra High Strength Continuous Cu/Nb and Cu/Ta Conductors for Non-Destructive Pulsed Fields Higher than 80 T", IEEE TRANSACTIONS ON APPLIED SUPERCONDUCTIVITY, IEEE SERVICE CENTER, LOS ALAMITOS, CA, US, vol. 12, no. 1, 1 mars 2002 (2002-03-01), XP011069256, ISSN: 1051-8223
- L THILLY: "Size-induced enhanced mechanical properties of nanocomposite copper/niobium wires: nanoindentation study", ACTA MATERIALIA, vol. 50, no. 20, 3 décembre 2002 (2002-12-03), pages 5049-5065, XP055007073, ISSN: 1359-6454, DOI: 10.1016/S1359-6454(02)00351-8

## Description

Le domaine de l'invention est celui des nanocomposites conducteurs et notamment des fils nanocomposites destinés à la fabrication de câbles pour la fabrication de bobines résistives non destructives.

De manière générale, la génération de champs magnétiques pulsés nécessite la fabrication de bobines résistives non destructives; pour cela, des matériaux présentant simultanément des propriétés mécaniques et électriques élevées sont nécessaires pour permettre de transporter le courant intense à l'origine du champ magnétique et de résister aux forces d'origine magnétique (forces de Lorentz) tendant à faire éclater la bobine. A l'heure actuelle, les meilleurs candidats pour des bobines générant des champs supérieurs à 70 Teslas (T) sont des matériaux nanocomposites constitués de nanostructures de niobium (Nb) insérées dans une matrice de cuivre (Cu) pur.

Des études ont déjà été menées dans le domaine du développement des conducteurs renforcés (macro et nanocomposites) pour bobines champs intenses et notamment décrites dans les articles suivants : « Interface instability in the drawing process of copper/tantalum conductors », L.Thilly, J.Colin, F.Lecouturier, J.P. Peyrade, J.Grilhé, S.Askénazy, Acta Materiala, 47-3 (1999), 853; « Recent progress in the developpment of ultra high strength « continuous » Cu/Nb and Cu/Ta conductors for non-destructive pulsed fields higher than 80T », L.Thilly, F.Lecouturier , G.Coffe, S.Askénazy, IEEE Transactions on Applied Superconductivity, 12-1 (2002), 1181 ; «A rieview of established and emerging materials for use as high-field magnet conductors », K.Spencer, F.Lecouturier, L.Thilly, J.D.Embury, Advanced engineering Materials, 6-5 (2004), 290-297 ; « Identification of aging mechanisms for non destructive pulsed magnets operating in the 60T range », J.Billette, F.Lecouturier, O.Portugall, IEEE Transactions on Applied Superconductivity (2004), vol 14, n°2, 1237-1240.

Les conducteurs nanocomposites étudiés et/ou fabriqués à base de matrice de cuivre et de nanotubes de niobium souffrent néanmoins actuellement de la présence de défauts internes entraînant des ruptures et empêchant l'obtention de fils composites nanostructurés de grande longueur, indispensables pour la fabrication des aimants.

C'est pourquoi la présente invention a pour objet de nouveaux fils conducteurs composites comportant un degré supplémentaire de nanomatériaux imbriqués les uns dans les autres comprenant des structures de nanotubes et nanofils. Ces nouveaux fils conducteurs permettent d'une part d'obtenir des matériaux exempts de défauts et de grande longueur ce qui permet d'envisager leur bobinage pour la fabrication des aimants pulsés et d'autre part d'obtenir des propriétés mécaniques et électriques élevées remplissant le cahier de charges imposé par les bobines de champs magnétiques pulsés très intenses (supérieurs typiquement à 70T).

Ils peuvent avantageusement être ainsi utilisés dans des applications telles que celles des électroaimants résistifs pulsés dans la gamme 60 à 100T et dans celles des électroaimants supraconducteurs à fonctionnement continu dans la gamme 10 à 25T.

L'invention a ainsi pour objet un fil composite conducteur comportant au moins une enveloppe externe en cuivre caractérisé en ce qu'il comprend en outre :
- un premier tube constitué d'un premier matériau métallique en contact et situé à l'intérieur de ladite enveloppe de cuivre ;
- un second tube constitué d'un second matériau métallique et en contact et situé à l'intérieur dudit premier tube ;
- une fibre constituée d'un troisième matériau métallique et en contact et situé à l'intérieur dudit second tube ;
- le cuivre et le premier matériau étant non miscibles entre eux, les premier et second matériaux étant non miscibles entre eux, les second et troisième matériaux étant non miscibles entre eux,
- les dimensions radiales des tubes et de la fibre étant sub-microniques.

L'intérêt d'introduire un niveau supplémentaire de matériau dans le fil composite de la présente invention, par rapport à l'art antérieur, réside notamment dans l'augmentation des performances mécaniques du fil composite ainsi obtenu par effet de taille et dans l'obtention d'une nanostructuration plus rapide

Selon une variante de l'invention, le premier matériau et le troisième matériau sont en niobium, le second matériau étant en cuivre.

Selon une variante de l'invention, les dimensions radiales des tubes et des fibres sont sub-microniques.

Selon une variante de l'invention, l'enveloppe externe présente une géométrie hexagonale.

L'invention a aussi pour objet une microstructure co-axiale à base de cuivre caractérisée en ce qu'elle comprend une gaine de cuivre contenant un ensemble de motifs élémentaires correspondant à des fils composites conducteurs selon l'invention.

Selon une variante de l'invention, le diamètre externe de la gaine étant de l'ordre du millimètre, elle comprend plusieurs milliers ou millions de motifs élémentaires composites conducteurs de dimensions sub-microniques.

L'invention a encore pour objet un procédé de fabrication d'une microstructure co-axiale selon l'invention, caractérisé en ce qu'il comprend les étapes suivantes :
- la réalisation d'une billette initiale cylindrique comportant une gaine en cuivre présentant un diamètre initial φ et contenant un premier tube constitué d'un premier matériau métallique en contact et situé à l'intérieur de ladite gaine de cuivre, un second tube constitué d'un second matériau métallique et en contact et situé à l'intérieur dudit premier tube, un troisième tube constitué d'un troisième matériau métallique et en contact et situé à l'intérieur dudit second tube, le cuivre et le premier matériau étant non miscibles entre eux, les premier et second matériaux étant non miscibles entre eux, les second et troisième matériaux étant non miscibles entre eux, cette structure co-axiale formant un motif élémentaire ;
- une série de i étapes élémentaires conduisant à la formation d'une ième billette à partir d'une (i-1)ème billette avec 1 ≤ i ≤ N et comportant :
   o la réduction de diamètre d'une (i-1)ème billette d'un facteur R de manière à obtenir une billette de diamètre φ/R ;
   o la mise en forme de ladite (i-1)ème billette dans une géométrie de type hexagonale ;
   o le tronçonnage en M éléments de ladite (i-1)ème billette de géométrie de type hexagonale ;
   o l'introduction des M tronçons dans une gaine en cuivre de manière à constituer une ième billette, les paramètres M et R étant du même ordre de grandeur et la Nième billette comprenant des motifs élémentaires de dimensions nanométriques.

Selon une variante de l'invention, l'étape de réduction de diamètre comprend les opérations suivantes :
- le traitement thermique de la billette pour une opération de filage à chaud ;
- l'extrusion de ladite billette portée en température ;
- l'étirage de ladite billette.

Selon une variante de l'invention, le premier matériau et le troisième matériau étant en niobium, le second matériau étant en cuivre, le traitement thermique est effectué à une température de l'ordre de 700°C.

Selon une variante de l'invention, le procédé comprend des étapes de dégazage desdites billettes avant les opérations de traitement thermique pour le filage.

Selon une variante de l'invention, le procédé comprend une première série d'étapes de fabrication de billettes comportant une étape de dégazage à une température de l'ordre de 200°C suivie d'une seconde série d'étapes de fabrication de billettes comportant une étape de dégazage à une température supérieure, de l'ordre de 400°C.

Selon une variante de l'invention, le nombre M est égal à 85.

Selon une variante de l'invention, le nombre N est de l'ordre de 4.

Il est à noter que selon le procédé de l'invention, plus on souhaite augmenter les propriétés mécaniques des microstructures co-axiales et plus le nombre N est élevé.

Par ailleurs, il est également à noter qu'il est possible de régler différents paramètres pour accéder à des dimensions voulues de microstructure, soit on privilégie, le taux de réduction de diamètre au cours d'une opération donnée d'étirage, soit on multiplie les opérations décrites précédemment en densifiant ladite microstructure en motifs élémentaires.

L'invention sera mieux comprise et d'autres avantages apparaîtront à la lecture de la description qui va suivre donnée à titre non limitatif et grâce aux figures annexées parmi lesquelles :
- la figure 1 illustre un exemple de motif élémentaire selon l'invention ;
- la figure 2 illustre une microstructure co-axiale selon l'invention à base de cuivre comprenant une gaine de cuivre contenant un ensemble de 85 motifs élémentaires selon l'invention ;
- la figure 3 illustre quelques étapes de procédé de fabrication d'une microstructure selon l'invention.

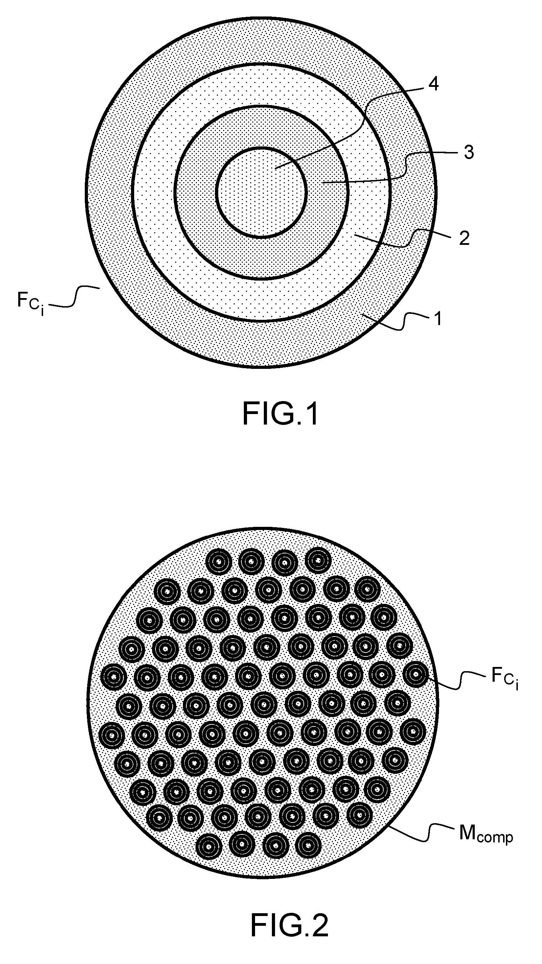

De manière générale, un motif élémentaire F_{ci}, selon l'invention comprend comme illustré en figure 1 :
- une enveloppe externe de cuivre 1 ;
- un premier tube 2 en matériau non miscible avec le cuivre et pouvant avantageusement être du niobium ;
- un second tube 3 en matériau non miscible avec le niobium, et pouvant en l'occurrence avantageusement être également en cuivre ;
- un filament 4 en matériau non miscible avec le cuivre et donc pouvant avantageusement également être en niobium.

Selon les applications ciblées, ce motif élémentaire peut typiquement présenter des dimensions radiales de l'ordre de quelques dizaines de nanomètres et présenter des performances mécaniques tout à fait satisfaisantes lorsque présent en grand nombre dans une matrice de cuivre.

A partir d'un ensemble de motifs élémentaires, on peut concevoir une microstructure co-axiale. Ainsi, la microstructure de l'invention, M_{comp} comprend dans une gaine en cuivre, un ensemble de motifs F_{ci} composites élémentaires, comme illustré en figure 2. Typiquement le diamètre de la gaine de cuivre peut être de l'ordre de quelques dizaines de micromètres. Ainsi, la présente invention permet d'obtenir une microstructure renforcée mécaniquement par la présence de trois phases de dimensions nanométriques et permet une géométrie de la distribution du renfort contrôlée tout en conservant la géométrie initiale en cours de procédé de fabrication comme explicité ci-après ce qui en facilite le procédé de fabrication.

Nous allons décrire en détails un exemple de procédé de fabrication d'une telle microstructure avec des étapes de procédé optimisées de manière à renforcer les propriétés mécaniques et conductrices de ladite microstructure co-axiale.

Le(s) demandeur(s) exploite(nt) notamment certaines étapes d'ores et déjà décrites dans la littérature concernant l'optimisation de conditions d'étirage à froid des systèmes nanofilamentaires CuNb et co-cylindriques CuNbCu et concernant plus précisément le développement et optimisation du procédé ADB « Accumulative Drawing and Budling », afin de limiter l'apparition des défauts permettant d'atteindre les dimensions nanométriques et la possibilité d'améliorer les conditions d'extrusion en appliquant la même optimisation que pour l'étirage, c'est-à-dire en modifiant l'angle des filières et aussi la température. A cet égard, on peut citer notamment les articles suivants : « Optimisation des propriétés mécaniques des conducteurs nanofilamentaires Cu/X avec X= Nb ou Ta, par l'étude des mécanismes élémentaires de déformation », V.Vidal, Thèse de Doctorat INSAT n°855, 11 décembre 2006 ; « Elaboration by severe plastic déformation, microstructural and mechanical study of Cu/X avec X=Nb ou Ta, nanofilamentary wires for the use in high field magnets », V.Vidal, L.Thilly, F.Lecouturier, Materials Science Form, 503-504 (2006), 639-644.

Concernant les étapes d'extrusion à chaud, il est également possible de se reporter aux articles suivants : «Size effects on the magnetic properties of Cu-Nb nanofilamentary processed by severe plastic deformation », M.J.R. Sandim, D.Stamopoulos, H.R.Z.Sansim, L.Ghivelder, L.Thilly, V.Vidal, F.Lecouturier, D.Raabe, Superconducting Science and Technology 19 (2006) 1233-1239; « Magnetism and Superconductivity in low dimensional systems : Utilisation in Future Applications », published by NOVA Science, New York (www.novapublishers.com), edited by Dismosthenis Stamopoulos (Inst. of Materials Science, Athens, Greece), 2008 ; « Superconductivity and magnetic properties of multifilamentary Cu-Nb micro/nano composite wires », M.Sandim, H.R.Z.Sandim, L.Ghivelder, L.Thilly, F.Lecouturier, D.Stamopoulos.

L'ensemble des étapes principales appelé Etages sont les suivantes :

### Etage 0 :

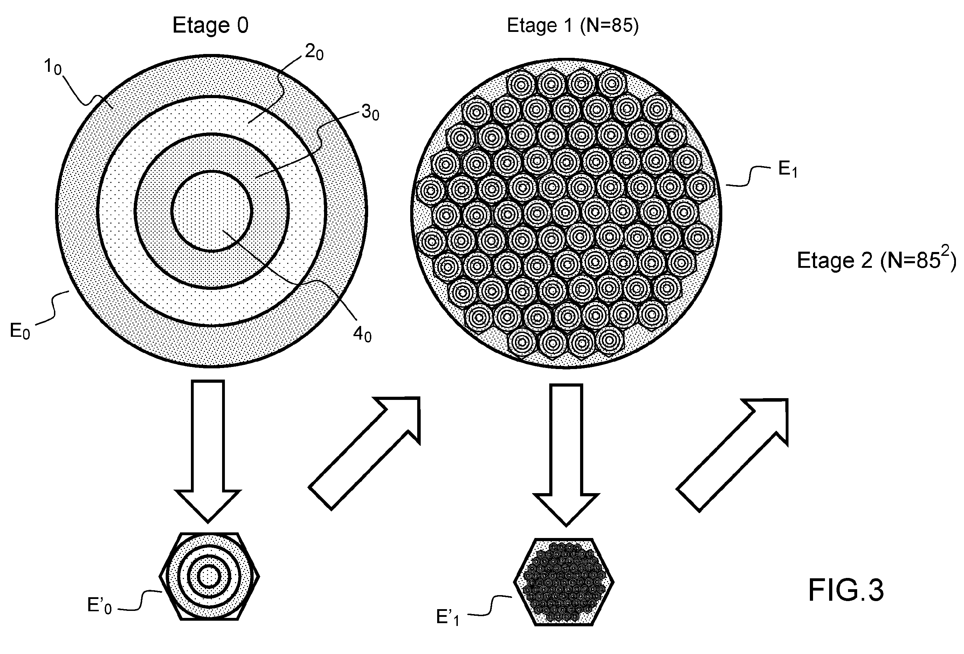

Un barreau 4₀ de Nb correspondant au troisième matériau de diamètre Φ₃ = 10 mm est inséré dans un tube de cuivre 3₀ correspondant au second matériau de diamètre externe Φ₂ₑ = 25 mm et de diamètre intérieur Φ₂ᵢ = 10 mm, lui-même inséré dans un tube 2₀ de Nb correspondant au premier matériau de diamètre extérieur Φ₃ₑ = 35 mm et de diamètre intérieur 25 mm, comme représenté en figure 3.

Cet assemblage est placé dans une gaine en cuivre 1₀ de diamètre extérieur Φ_{eG} = 44 mm et de diamètre intérieur Φ_{iG} = 35 mm, dont les extrémités sont obturées et étanchéifiées par des embouts en cuivre. On obtient ainsi une billette dite initiale E₀.

On procède alors au dégazage de la billette initiale pendant deux heures à une température de 200°C.

La billette E₀ subit un traitement thermique pendant deux heures à 700°C, avant le filage à chaud avec un rapport de réduction de section de 8,6.

Après extrusion, la billette E₀ est étirée à température ambiante dans des conditions optimisées (avec un taux de réduction par passe et des angles des filières optimisés) dans des filières de géométrie cylindrique jusqu'à atteindre un diamètre de 4,51 mm.

Le demandeur a optimisé par résultats d'expérience des valeurs de taux de réduction inférieur ou égal à 20% et un angle de filière inférieur à 20°, permettant par la même de réduire les défauts internes et les problèmes de co-déformation. La barre étirée issue de la billette E₀ est ensuite étirée et simultanément mise en forme dans des filières hexagonales jusqu'à obtenir une forme extérieure hexagonale de hauteur 3,70 mm, pour obtenir la billette E'₀, permettant d'optimiser l'arrangement ultérieur desdits fils composites conducteurs au sein d'une gaine de cuivre.

La barre hexagonale est découpée en 85 tiges qui sont redressées ; (en effet, les segments obtenus étant parfois courbes, sont avantageusement redressés).

Les 85 tiges sont décapées.

### Etage 1 :

Les 85 tiges hexagonales issues de la billette E'₀ sont empilées et placées dans une gaine de cuivre de même diamètres externe et interne que ceux de la billette E₀, (Φ_{eG} = 44 mm et Φ_{iG} = 35 mm), pour former une billette E₁.

La billette E₁ subit alors le même traitement que la billette E₀. La figure 3 illustre la réduction de billette, la multiplication desdites billettes réduites et leur intégration dans une nouvelle gaine de cuivre.

### Etage 2 :

Les 85 tiges hexagonales issues de la billette E'₁ sont empilées et placées dans une gaine de cuivre de même diamètres externe et interne que ceux de la billette E₀, (Φ_{eG} = 44 mm et Φ_{iG} = 35 mm), pour former une billette E₂.

La billette E₂ subit alors le même traitement que la billette E₁.

### Etage 3 :

Les 85 tiges hexagonales issues de la billette E₂ sont empilées et placées dans une gaine de cuivre de même diamètres externe et interne que ceux de la billette E₀, (Φ_{eG} = 44 mm et Φ_{iG} = 35 mm), pour former une billette E₃.

La billette E₃ est alors dégazée de manière optimisée, à une température de 400°C durant deux heures. Le(s) demandeur(s) a(ont) observé qu'à ce niveau de réduction de dimensions et à ce degré de densification des éléments, il devenait nécessaire de procéder à des opérations de dégazage à des températures supérieures à celles des dégazages opérés dans les étages précédents.

La billette E₃ subit un traitement thermique pendant deux heures à 700°C avant le filage à chaud avec un rapport de section de 8,6.

Après extrusion, la billette E₃ est étirée à température ambiante dans des conditions optimisées (avec un taux de réduction par passe et angles des filières optimisées) dans des filières de géométrie cylindrique jusqu'à atteindre un diamètre de 3,85mm.

Selon une première alternative, on prépare un Etage 4 optionnel.

La barre étirée issue de la billette E₃ est ensuite étirée et simultanément mise en forme dans des filières hexagonales jusqu'à l'obtention d'une forme extérieure hexagonale de hauteur 3,35 mm de façon à réaliser une nouvelle billette E₄.

La barre hexagonale est découpée en 85 tiges qui sont redressés. Les 85 tiges sont décapées.

Selon une seconde alternative, pour l'obtention de conducteurs renforcés de l'Etage 3.

La billette E₃ au diamètre de 3,85 mm est étirée jusqu'à des diamètres inférieures à 0,8 mm sans aucune rupture.

Un conducteur renforcé de diamètre 2,064 mm est constitué de nanofibres de Nb de 322m de diamètre théorique et de nanotubes de Nb de 161 nm d'épaisseur théorique. Sa résistivité électrique est de 2,277 µohm.cm (soit 75,7 % IACS : référence de cuivre pur en norme IACS) à température ambiante et de 0,496 µohm.cm à 77 K. Sa résistance à la traction est supérieure à 873 MPa à 77K

Un conducteur renforcé de diamètre 0,875 mm est constitué de nanofibres de Nb de 136 nm de diamètre théorique et de nanotubes de Nb de 68 nm d'épaisseur théorique. Sa résistivité électrique est de 2,335 µohm.cm (soit 73,8 % IACS) à température ambiante et de 0,561 µohm.cm à 77K. Sa résistance à la traction est supérieure à 1087 MPa à 77K.

Selon les propriétés mécaniques ultimes recherchées, on peut prolonger le procédé jusqu'à un Etage 4 afin d'optimiser davantage les propriétés de la microstructure obtenue.

### Etage 4 optionnel :

Les 85 tiges de forme hexagonale, issues de la première alternative, sont empilées et placées dans une gaine de cuivre de diamètres identiques à ceux des gaines précédentes (Φ_{eG} = 44 mm et Φ_{iG} = 35 mm) pour former la billette E₄.

A ce stade, l'épaisseur de la gaine de cuivre est augmentée de façon à s'affranchir de tout risque de fissuration de cette même gaine lors de la phase d'étirage.

La billette E₄ subit le même traitement que celui précédemment décrit pour la billette E₃ et poursuivi suivant la voie 2 : la billette E₄ est alors dégazée de manière optimisée, à une température de 400°C durant deux heures. La billette E₄ subit un traitement thermique pendant deux heures à 700°C avant le filage à chaud avec un rapport de section de 8,6.

Après extrusion, la billette E₄ est étirée à température ambiante dans des conditions optimisées (avec un taux de réduction par passe et angles des filières optimisées) dans des filières de géométrie cylindrique jusqu'à atteindre un diamètre correspondant aux propriétés visées.

Ainsi les microstructures co-axiales de l'invention peuvent être utilisées pour réaliser des bobines pour aimants pulsés, la nanostructuration du composite cuivre/niobium permet de repousser la limite élastique du conducteur au delà de 1GPa et donc de supporter les contraintes très élevées créées par les forces de Lorentz dans le bobinage tout en maintenant une bonne conductivité électrique du cuivre pour le transport du courant.

## Revendications

1. Fil composite conducteur comportant au moins une enveloppe externe (1) en cuivre **caractérisé en ce qu'**il comprend en outre :
- un premier tube (2) constitué d'un premier matériau métallique en contact et situé à l'intérieur de ladite enveloppe de cuivre ;
- un second tube (3) constitué d'un second matériau métallique et en contact et situé à l'intérieur dudit premier tube ;
- une fibre (4) constitué d'un troisième matériau métallique et en contact et situé à l'intérieur dudit second tube ;
- le cuivre et le premier matériau étant non miscibles entre eux, les premier et second matériaux étant non miscibles entre eux, les second et troisième matériaux étant non miscibles entre eux ;
- les dimensions radiales des tubes et de la fibre étant sub-microniques.

2. Fil composite conducteur selon la revendication 1, **caractérisé en ce que** le premier matériau et le troisième matériau sont en niobium, le second matériau étant en cuivre.

3. Fil composite conducteur selon l'une des revendications 1 à 2, **caractérisé en ce que** l'enveloppe externe présente une géométrie hexagonale.

4. Microstructure co-axiale à base de cuivre **caractérisée en ce qu'**elle comprend une gaine de cuivre contenant un ensemble de motifs élémentaires correspondants à des fils composites conducteurs selon l'une des revendications 1 à 3.

5. Microstructure co-axiale selon la revendication 4, **caractérisée en ce que** le diamètre externe de la gaine étant de l'ordre du millimètre, elle comprend plusieurs milliers ou millions de motifs élémentaires de dimensions sub-microniques.

6. Procédé de fabrication d'une microstructure co-axiale selon l'une des revendications 4 ou 5, **caractérisé en ce qu'**il comprend les étapes suivantes :
- la réalisation d'une billette initiale (E₀) cylindrique comportant une gaine en cuivre présentant un diamètre de référence (Φ_{R}) et contenant un premier tube (2) constitué d'un premier matériau métallique (M₁) en contact et situé à l'intérieur de ladite gaine de cuivre, un second tube (3) constitué d'un second matériau métallique (M₂) et en contact et situé à l'intérieur dudit premier tube, un troisième tube constitué d'un troisième matériau métallique (M₃) et, en contact et situé à l'intérieur dudit second tube, le cuivre et le premier matériau étant non miscibles entre eux, les premier et second matériaux étant non miscibles entre eux, les second et troisième matériaux étant non miscibles entre eux ;
- une série de i étapes élémentaires conduisant à la formation d'une ième billette à partir d'une (i-1)ème billette ave 1≤ i ≤ N et comportant :
o la réduction de diamètre d'une (i-1)ème billette d'un facteur R de manière à obtenir une billette de diamètre Φ/R ;
o la mise en forme de ladite (i-1)ème billette dans une géométrie de type hexagonale ;
o le tronçonnage en M éléments de ladite (i-1)ème billette de géométrie de type hexagonale ;
o l'introduction des M tronçons dans une gaine en cuivre de manière à constituer une ième billette (Eᵢ).

7. Procédé de fabrication d'une microstructure co-axiale selon la revendication 6, **caractérisé en ce que** l'étape de réduction de diamètre comprend les opérations suivantes :
- le traitement thermique de la billette pour une opération de filage à chaud ;
- l'extrusion de ladite billette portée en température ;
- l'étirage de ladite billette.

8. Procédé de fabrication d'une microstructure co-axiale selon la revendication précédente, **caractérisé en ce que** le premier matériau et le troisième matériau étant en niobium, le second matériau étant en cuivre, le traitement thermique est effectué à une température de l'ordre de 700°C.

9. Procédé de fabrication d'une microstructure co-axiale selon l'une des revendications 7 ou 8, **caractérisé en ce qu'**il comprend des étapes de dégazage desdites billettes avant les opérations de traitement thermique pour le filage.

10. Procédé de fabrication d'une microstructure co-axiale selon la revendication 9, **caractérisé en ce qu'**il comprend une première série d'étapes de fabrication de billettes comportant une étape de dégazage à une température de l'ordre de 200°C suivie d'une seconde série d'étapes de fabrication de billettes comportant une étape de dégazage à une température supérieure de l'ordre de 400°C.

11. Procédé de fabrication d'une microstructure co-axiale selon l'une des revendications 6 à 10, **caractérisé en ce que** le nombre M est égal à 85.

12. Procédé de fabrication d'une microstructure co-axiale selon l'une des revendications précédentes, **caractérisé en ce que** le nombre N est de l'ordre de 4.

## Patentansprüche

1. Zusammengesetzter Leitungsdraht, der wenigstens einen äußeren Kupfermantel (1) umfasst, **dadurch gekennzeichnet, dass** er ferner Folgendes umfasst:
- eine erste Röhre (2) aus einem ersten metallischen Material in Kontakt mit dem Kupfermantel und darin befindlich;
- eine zweite Röhre (3) aus einem zweiten metallischen Material in Kontakt mit der ersten Röhre und darin befindlich;
- eine Faser (4) aus einem dritten metallischen Material in Kontakt mit der zweiten Röhre und darin befindlich;
- wobei der Kupfer und das erste Material nicht miteinander mischbar sind, wobei das erste und das zweite Material nicht miteinander mischbar sind, wobei das zweite und das dritte Material nicht miteinander mischbar sind;
- wobei die radialen Abmessungen der Röhren und der Faser im Submikronbereich liegen.

2. Zusammengesetzter Leitungsdraht nach Anspruch 1, **dadurch gekennzeichnet, dass** das erste Material und das dritte Material Niob sind, wobei das zweite Material Kupfer ist.

3. Zusammengesetzter Leitungsdraht nach einem der Ansprüche 1 bis 2, **dadurch gekennzeichnet, dass** der äußere Mantel eine hexagonale Geometrie hat.

4. Koaxiale Mikrostruktur auf Kupferbasis, **dadurch gekennzeichnet, dass** sie eine Kupferummantelung umfasst, das einen Satz von Basismustern enthält, die den zusammengesetzten Leitungsdrähten nach einem der Ansprüche 1 bis 3 entsprechen.

5. Koaxiale Mikrostruktur nach Anspruch 4, **dadurch gekennzeichnet, dass** sie, wenn der Außendurchmesser der Ummantelung etwa ein Millimeter beträgt, mehrere tausend oder Millionen Basismuster mit Submikronabmessungen umfasst.

6. Verfahren zur Herstellung einer koaxialen Mikrostruktur nach Anspruch 4 oder 5, **dadurch gekennzeichnet, dass** es die folgenden Schritte beinhaltet:
- Erzeugen einer zylindrischen Ausgangsstange (E₀), die eine Kupferummantelung mit einem Referenzdurchmesser (*φ*_{R}) umfasst und Folgendes beinhaltet: eine erste Röhre (2) aus einem ersten metallischen Material (M₁) in Kontakt mit der Kupferummantelung und darin befindlich, eine zweite Röhre (3) aus einem zweiten metallischen Material (M₂) in Kontakt mit der ersten Röhre und darin befindlich, eine dritte Röhre aus einem dritten metallischen Material (M₃) in Kontakt mit der zweiten Röhre und darin befindlich, wobei der Kupfer und das erste Material nicht miteinander mischbar sind, das erste und das zweite Material nicht miteinander mischbar sind, das zweite und das dritte Material nicht miteinander mischbar sind;
- eine Serie von i Grundschritten, die zur Bildung einer i-ten Stange von einer (i-1)-ten Stange führen, wobei 1 ≤ i ≤ N ist, und die Folgendes beinhalten:
∘ Reduzieren des Durchmessers einer (i-1)-ten Stange um einen Faktor R, um eine Stange mit einem Durchmesser *φ*/R zu erhalten;
∘ Formen der (i-1)-ten Stange zu einer Geometrie des hexagonalen Typs;
∘ Unterteilen der (i-1)-ten Stange mit einer Geometrie des hexagonalen Typs in M Elemente;
∘ Einführen der M Abschnitte in eine Kupferummantelung, um eine i-te Stange (Eᵢ) zu bilden.

7. Verfahren zur Herstellung einer koaxialen Mikrostruktur nach Anspruch 6, **dadurch gekennzeichnet, dass** der Schritt des Reduzierens des Durchmessers die folgenden Abläufe beinhaltet:
- Wärmebehandeln der Stange für einen Schmelzspinnvorgang;
- Extrudieren der erhitzten Stange;
- Strecken der Stange.

8. Verfahren zur Herstellung einer koaxialen Mikrostruktur nach dem vorherigen Anspruch, **dadurch gekennzeichnet, dass**, wenn das erste Material und das dritte Material Niob sind, wobei das zweite Material Kupfer ist, die Wärmebehandlung bei einer Temperatur von etwa 700°C durchgeführt wird.

9. Verfahren zur Herstellung einer koaxialen Mikrostruktur nach Anspruch 7 oder 8, **dadurch gekennzeichnet, dass** es Schritte des Entgasens der Stangen vor den Wärmebehandlungsvorgängen zum Schmelzspinnen beinhaltet.

10. Verfahren zur Herstellung einer koaxialen Mikrostruktur nach Anspruch 9, **dadurch gekennzeichnet, dass** es eine erste Serie von Schritten zur Herstellung von Stangen beinhaltet, die einen Schritt des Entgasens bei einer Temperatur von etwa 200°C beinhaltet, gefolgt von einer zweiten Serie von Schritten zur Herstellung von Stangen, die einen Schritt des Entgasens bei einer höheren Temperatur von etwa 400°C beinhaltet.

11. Verfahren zur Herstellung einer koaxialen Mikrostruktur nach einem der Ansprüche 6 bis 10, **dadurch gekennzeichnet, dass** die Zahl M 85 ist.

12. Verfahren zur Herstellung einer koaxialen Mikrostruktur nach einem der vorherigen Ansprüche, **dadurch gekennzeichnet, dass** die Zahl N etwa 4 ist.

## Claims

1. A composite conductive wire comprising at least one outer copper sheath (1), **characterised in that** it further comprises:
- a first tube (2) made up of a first metallic material in contact with and being located inside said copper sheath;
- a second tube (3) made up of a second metallic material in contact with and being located inside said first tube;
- a fibre (4) made up of a third metallic material in contact with and being located inside said second tube;
- the copper and the first material being immiscible with each other, the first and second materials being immiscible with each other, the second and third materials being immiscible with each other;
- the radial dimensions of the tubes and of the fibre being sub-micron sized.

2. The composite conductive wire according to claim 1, **characterised in that** the first material and the third material are niobium, with the second material being copper.

3. The composite conductive wire according to any one of claims 1 to 2, **characterised in that** said outer sheath has a hexagonal geometry.

4. A copper-based coaxial microstructure, **characterised in that** it comprises a copper tubing containing a set of basic patterns corresponding to the composite conductive wires according to any one of claims 1 to 3.

5. The coaxial microstructure according to claim 4, **characterised in that**, as the outer diameter of the tubing is approximately one millimetre, it comprises several thousand or million basic patterns with sub-micron sized dimensions.

6. A method for manufacturing a coaxial microstructure according to any one of claims 4 or 5, **characterised in that** it comprises the following steps:
- producing an initial cylindrical rod (E₀) comprising a copper tubing having a reference diameter (*φ*_{R}) and containing a first tube (2) made up of a first metallic material (M₁) in contact with and being located inside said copper tubing, a second tube (3) made up of a second metallic material (M₂) in contact with and being located inside said first tube, a third tube made up of a third metallic material (M₃) in contact with and being located inside said second tube, with the copper and the first material being immiscible with each other, the first and second materials being immiscible with each other, the second and third materials being immiscible with each other;
- a series of i basic steps resulting in the formation of an i-th rod from an (i-1)-th rod, with 1 ≤ i ≤ N, and comprising:
∘ reducing the diameter of an (i-1)-th rod by a factor R so as to obtain a rod with a diameter *φ*/R;
∘ shaping said (i-1)-th rod into a geometry of the hexagonal type;
∘ dividing said (i-1)-th rod with a geometry of the hexagonal type into M elements;
o introducing the M sections into a copper tubing so as to form an i-th rod (Eᵢ).

7. The method for manufacturing a coaxial microstructure according to claim 6, **characterised in that** the step of reducing the diameter comprises the following operations:
- heat treating the rod for a melt spinning operation;
- extruding said heated rod;
- drawing said rod.

8. The method for manufacturing a coaxial microstructure according to the preceding claim, **characterised in that**, as the first material and the third material are niobium, with the second material being copper, the heat treatment is carried out at a temperature of approximately 700°C.

9. The method for manufacturing a coaxial microstructure according to any one of claims 7 or 8, **characterised in that** it comprises steps of degassing said rods before the heat treatment operations for melt spinning.

10. The method for manufacturing a coaxial microstructure according to claim 9, **characterised in that** it comprises a first series of steps of manufacturing rods comprising a step of degassing at a temperature of approximately 200°C, followed by a second series of steps of manufacturing rods comprising a step of degassing at a higher temperature of approximately 400°C.

11. The method for manufacturing a coaxial microstructure according to any one of claims 6 to 10, **characterised in that** the number M is 85.

12. The method for manufacturing a coaxial microstructure according to any one of the preceding claims, **characterised in that** the number N is approximately 4.
